Europäisches Patentamt

European Patent Office

Office européen des brevets

(11) Publication number: **0 340 401**

**A1**

## (12) EUROPEAN PATENT APPLICATION

(21) Application number: **89103266.6**

(22) Date of filing: **24.02.89**

(51) Int. Cl.⁴: **C04B 35/00 , H01L 39/24**

(30) Priority: **02.05.88 US 188926**
**07.07.88 US 215962**

(43) Date of publication of application:
**08.11.89 Bulletin 89/45**

(84) Designated Contracting States:
**AT BE CH DE ES FR GB GR IT LI LU NL SE**

(71) Applicant: **W.R. Grace & Co.-Conn. (a Connecticut corp.)**
**Grace Plaza 1114 Avenue of the Americas New York New York 10036(US)**

(72) Inventor: **Block, Jacob**
**14112 Parkvale Road**
**Rockville, MD 20853(US)**
Inventor: **Dolhert, Leonard Edward**
**13324 Elliott Drive**
**Clarksville, MD 21029(US)**

(74) Representative: **Abitz, Walter, Dr.-Ing. et al**
**Abitz, Morf, Gritschneder, Freiherr von Wittgenstein Postfach 86 01 09**
**D-8000 München 86(DE)**

(54) Dry monocarboxylate mixtures.

(57) A solution of the monocarboxylates of Y or Ca, Ba, and Cu is spray dried, providing a contaminant-free non-hygroscopic product which is homogeneous at the atomic level. In one preferred embodiment Y, Ba, and Cu formates or acetates are used in a molecular ratio of 1:2:3, giving a product which can be calcined to give a superconducting mixed oxide, $YBa_2Cu_3O_x$, where x is 6.8-7.0. In another embodiment, a solution of the monocarboxylates (e.g., formates or acetates) of Ca, Ba, and Cu is dried, calcined, mixed with $Tl_2O_3$, and the mixture is heated to make a superconductor. The method minimizes introduction of contaminants.

EP 0 340 401 A1

## DRY MONOCARBOXYLATE MIXTURES

### Field of the Invention

This invention relates to mixed ceramic oxide systems and improvements in preparing same.

### Summary of the Invention

A solution of the monocarboxylates of X, Ba and Cu, wherein X is either Ca or Y, is prepared. The solvent is removed by conventional means, preferably by spray drying, providing a contaminant-free, non-hygroscopic, homogeneous product. The dried, mixed monocarboxylates are calcined. In one embodiment, Y, Ba and Cu acetates are used in a molecular ratio of 1:2:3, giving a superconducting mixed oxide $YBa_2Cu_3O_x$, where x is 6.8-7.0. In a second embodiment, Ca, Ba and Cu acetates are calcined, mixed with $Tl_2O_3$ and heated. The result is superconducting.

### Background of the Invention

It has long been known that the effective resistivity of certain metals was sometimes substantially eliminated when the metal was exposed to low temperature conditions. Of particular interest were the metals and metal oxides which can conduct electricity under certain low temperature conditions with virtually no resistance. These have become known as superconductors. Certain metals, for example, are known to be superconductive when cooled to about 4° on the Kelvin scale (°K), and certain niobium alloys are known to the superconductive at about 15° K, some as high as about 23° K.

Discovery of superconductivity in the system La-Ba-Cu-O (J. G. Bednorz and K. A. Muller, Zeit. Phys. B 64, 189-193 [1986]) and in the system Y-Ba-Cu-O (Wu et al., Phys. Rev. Lett. 58, 908-910 [1987]) has stimulated the search for other systems, particularly with a view to substituting other elements for the rare earths (RE) used in the earlier materials. For example, replacement of RE by Bi and Tl has been reported. In preparing the system Tl-Ba-Cu-O, Z. Z. Sheng and A. M. Hermann (Superconductivity in the Rare Earth-Free Tl-Ba-Cu-O System above Liquid Nitrogen Temperature) Nature, 332, pp. 55-58 (1988), first mixed and ground $BaCO_3$ and CuO to obtain a product which they heated, then intermittently reground to obtain a uniform black Ba-Cu-Oxide powder, which was then mixed with $Tl_2O_3$, ground, and heated, with formation of a superconducting material. It was noted that the Tl oxide partially melted and partially vaporized.

The superconductor system Tl-Ca-Ba-Cu-O was also reported in a paper by Sheng and Hermann, "Bulk Superconductivity at 120 K in the Tl-Ca/Ba-Cu-O System" Nature, 332, pp. 138-39 (1988). The authors reported "stable and reproducible bulk superconductivity above 120 K with zero resistance above 100 K." According to the paper the composition was prepared by mixing and grinding together $Tl_2O_3$, CaO, and $BaCu_3O_4$. The ground mixture was pressed into a pellet and heated in flowing oxygen. The result was cooled and found to be superconducting.

See also the paper by Hazen et al., "100 K Superconducting Phases in the Tl-Ca-Ba-Cu-O System" Phys. Rev. Lett., 60, pp. 1657-1660 (1988), which refers to two superconducting phases, $Tl_2$ $Ca_2$ $Ba_2$ $Cu_3O_{10+\delta}$ and $Tl_2Ca_1Ba_2Cu_2O_{8+\delta}$, both with onset $T_c$ near 120 K and zero resistivity at 100 K. Preparation included grinding together $Tl_2O_3$, CaO, and $BaCu_3O_4$ (or $Ba_2Cu_3O_5$), followed by heating.

And see "Nota Bene" in High $T_c$ Update, Vol. 2, No. 6, p. 1, March 15, 1988, further re properties of the Tl-Ca-Ba-Cu-O system.

It is known that improved homogeneity in the general case enhances superconductivity. Prior art processes conventionally enhance homogeneity by grinding the calcined intended superconductor, followed by recalcining. In some instances this sequence may be repeated several times. The problem here is that effective grinding inevitably and inherently introduces impurities into the ceramic, simply by impacting the ceramic between the balls or walls (or other grinding surfaces) of the grinding mill. It is known, for example, that silica or stainless steel balls in a ball mill lose significant mass over a period of use. This mass, of course, disappears into whatever was being milled. Mills that comminute by particle self-impact lose metal by wall scouring, particularly in the area of stream entry. If the product is ground in a ball mill using quartz or silica balls, some of the impurity is silica.

Thus, the firing-grinding-refining technique rapidly achieves a balance: improvement in homogeniety tends to be matched by contamination build-up that cancels all or part of the improvement.

One method of preparing a pure mixture of salts of yttrium, barium, and copper is to spray dry an aqueous solution of the nitrates; see, for example, CA Selects: Cooloids, (Applied Aspects), Issue 12, 1988, 108:208961V, disclosing spray drying an aqueous solution of Y, Ba, and Cu nitrates.

Spray drying the nitrates does indeed avoid introduction of impurities, preserves the stoichiometry of the starting ingredients, and provides ready anion burn-off, leaving the pure mixed Y-Ba-Cu oxides, homogeneous at the atomic level. All of these features are important in the conversion of the mixed nitrates to a superconductor. However, from the production viewpoint, spray drying the solution of mixed nitrates suffers a serious disadvantage in that the spray dried nitrate product is hygroscopic. The product begins to absorb atmospheric moisture as soon as it is removed from the dryer, and it will quickly clump and cake, and will not flow freely. In this form it is difficult to process further. Handling requires minimal ambient exposure, and storage and shipping requires immediate hermetic sealing.

This invention provides a non-hygroscopic spray dried product and therefore avoids the foregoing problems. A mixture of monocarboxylates is substituted for the stated nitrates, other conditions being substantially the same. These monocarboxylates are the formates, acetates, propionates and butyrates, being those generally derivable from monocarboxylic acids of the formula RCOOH, where R is H or alkyl of 1-4 carbons. A suitable monocarboxylate concentration for spray drying is about 10-15%.

Under the process of this invention, a homogeneous, non-hydroscopic mixture is obtained with minimal introduction of impurities.

The invention is applicable generally to the system $X_b$-$Ba_c$-$Cu_d$-$O_e$ where b and c are independently about 0.5-3, preferably 1 or 2; d is about 1-4, preferably 2 or 3; e is indeterminate, depending on the mixture, and X is either Ca or Y.

In one particular aspect, the invention is applicable generally to the system $Tl_a$-$Ca_b$-$Ba_c$-$Cu_d$-$O_e$, where a, b, and c are independently about 0.5-3, preferably 1 or 2; d is about 1-4, preferably 2 or 3; and e is indeterminate, depending on the mixture. Such compounds include:

    A. $Tl_2$-$Ca_2$-$Ba_2$-$Cu_3O_{10+\delta}$;
    B. $Tl_2$-$Ca_1$-$Ba_2$-$Cu$-$O_{8+\delta}$;
    C. $Tl_1$-$Ca_1$-$Ba_1$-$Cu_2$-$O_x$;
    D. $Tl_1$-$Ca_3$-$Ba_1$-$Cu_3$-$O_x$; and the like.

In the above, A is made in Example 4. C has been suggested as the component that provides actual superconductivity. ("Nota Bene" in High $T_c$ Update, op. cit.) The indicator "delta" ( ) follows the art convention and designates an undetermined value of 1 or less.

The invention provides several novel compositions and processes:

Compositions:

1) Solution of monocarboxylates of X, Ba and Cu wherein X is either Ca or Y. Total solids (monocarboxylates) is about 5-25% of solution, and X, Ba and Cu are present in an atomic ratio of $X_b$-$Ba_c$-$Cu_d$, where b is about 0.5-3, c is about 0.5-3 and d is about 1-4.

2) The dried homogeneous mixture of the monocarboxylates of X, Ba and Cu wherein X is either Ca or Y.

3) The homogeneous mixture of the oxides of X, Ba and Cu wherein X is either Ca or Y.

4) The unfired mixture of the oxides of Ca, Ba and Cu, plus $Tl_2O_3$, providing $Tl_a$-$Ca_b$-$Ba_c$-$Cu_d$-O where a is about 0.5-3 and b, c and d are as above defined.

5a) The fired mixture of 3 above, wherein X is Y (superconductor).

5b) The fired mixture of 4 above (superconductor).

Comment: The point of novelty of Compositions 5a) and 5b), vis-a-vis the prior art, is that Y, Ba and Cu oxides or Ca, Ba and Cu oxides are, respectively, present in totally homogenized form, owing to their formation from the original homogeneously dispersed monocarboxylates.

Processes:

6) Forming a solution of monocarboxylates of X, Ba, and Cu, suitably to provide an atomic ratio of $X_b$-$Ba_c$-$Cu_d$ as above defined, wherein X is either Ca or Y.

7) Drying (6). Drying can be done in an oven (cf. our Example 1), or (preferably) by spray drying, or by spraying the solution onto a heated drum, or by substantially any conventional means.

8) Heating the dried monocarboxylate mixture to convert the monocarboxylates to oxide, thereby forming a homogeneous mixture of the oxides of X, Ba, and Cu, wherein X is either Ca or Y.

9) Intimately admixing the oxide mixture of (8), wherein X is Ca with $Tl_2O_3$ to provide an atomic ratio of $Tl_a$-$Ca_b$-$Ba_c$-$Cu_d$-O where a, b, c, and d are as above defined.

10) Calcining the oxide mixture of (9) to form a superconductor.

11) Calcining the oxide mixture of (8), wherein X is Y, to form a superconductor.

Although acetates were used in the examples, actually any of the lower monocarboxylates are suitable, i.e., formates, propionates, or butyrates. Further, mixtures of these salts are useful, e.g., a mixture of calcium acetate, barium formate, and copper propionate; or a mixture of calcium formate, barium propionate, and copper acetate, etc. The permutative possibilities are numerous and are not critical.

Also, instead of water, the solvent may be a lower monohydroxyalkanol (1-4 carbons), e.g., ethanol. For economic reasons use of the formates or acetates in water solvent is preferred.

Preferably, the monocarboxylate solution is spray dried. Spray drying the monocarboxylates avoids the introduction of impurities, preserves the stoichiometry of the starting ingredients, provides a non-hygroscopic product, and provides ready anion burn-off, leaving the pure mixed X-Ba-Cu oxides, homogeneous at the atomic level. All of these features are important in the conversion of the mixed carboxylates to a superconductor. These monocarboxylates are the formates, acetates, propionates, and butyrates, being those generally derivable from monocarboxylic acids of the formula RCOOH; where R is H or alkyl of 1-4 carbons. A suitable monocarboxylate concentration for spray drying is about 10-15%. The spray-dried product is a powder and does not require grinding. The spray-dried product is calcined to a mixed oxide. In this way no grinding at any stage is required. The powdered (Ca-Ba-Cu) oxide-$Tl_2O_3$ mixture can be taken directly to the furnace and fired to convert the Tl-Ca-Ba-Cu oxide mix to a superconducting powder. As will be evident from this technique, not only is the $Tl_2O_3$ not heated as the monocarboxylate -- it is not heated at all until it is in proper stoichiometric oxide-admixture with the Ca-Ba-Cu oxide mixture.

The invention thus offers at least four closely related contributions to the art: (1) total homogeneity of the X-Ba-Cu oxides, wherein X is Ca or Y; (2) minimal handling of toxic Tl; (3) zero Tl loss during calcining and therefore better control of stoichiometry; and (4) minimal introduction of impurities. The preferred use of formates or acetates in water as above described avoids grinding and the introduction of impurities resulting from grinding. The following examples involve some grinding, but only on a small lab scale, and without introduction of sufficient impurities to destroy superconductivity. In some examples there are two grinding steps, the first being the step of grinding the dried acetate mixture, and the second being grinding thallium oxide with the calcined Ca-Ba-Cu oxide. However, the sum of these grinding steps is less than the art practice of starting with all oxides and/or carbonates, since in the claimed process Ca, Ba, and Cu are already completely and homogeneously mixed at the outset.

As used herein, the term "homogeneous" means dispersion so fine that it is practically at the atomic level. This is the type of homogeneity that results when, e.g., an acetate solution is dried and calcined. Subsequent admixture with $Tl_2O_3$, even

with repeated grinding, does not give the same degree or type of dispersion. it is known of course, that such mixing and grinding is operative, both in the prior art as well as in the invention. It does, however, tend to introduce traces of impurities.

The following examples illustrate without limiting our invention.

## Example 1

### Preparation of Mixed Acetates

$CaCO_3$ (20.0 g) was dissolved in an acetic acid solution (70 g of glacial acetic acid in 850 g distilled $H_2O$). $BaCO_3$ (39.5 g) was then dissolved in the above solution. Cupric acetate monohydrate (59.9 g) was dissolved in the above solution with an additional 50 g of distilled $H_2O$. The solution was dried in glass trays in an oven at 150° (16 hours).

## Example 2

### Preparation of $Ca_2Ba_2Cu_3$ Oxides

The dried product of Example 1 was ground with a mortar and pestle, and then calcined at 500° C (8 hours). The product was a soft, easily ground, grey powder. The weight loss was 40.1%.

## Example 3

### Preparation of Thallium Barium Calcium Copper Oxide Superconducting Powder

The calcined product of Example 2 (10.0 g) was mixed with $Tl_2O_3$ (7.0 g) with a mortar and pestle. The mixed powder was placed in an alumina boat, fired to 850° C, and held at this temperature for 5 hours. The resulting black powder was pressed into a pellet, which, when cooled in liquid nitrogen, repelled a magnet, thus showing the Meissner effect and indicating superconductance. Total weight loss in this step was 35.8%.

## Example 4

Pelletizing Tl-Ca-Ba-Cu Oxide Powder

Powder prepared as in Example 3 (8.57 g) was pressed into a 1-1/8" diameter disk-pellet at 4000 psi. The disk was placed in a tube furnace under flowing $O_2$ and heated to 850°C in 4 hours and 10 minutes. The sample was held at 865°C for 6 hours, and then cooled to room temperature in 12 hours. The weight loss was 4.1%. The disk floated a rare earth magnet (ca. 3.6 g) in liquid nitrogen. The $T_c$ was found to be 105°K on cooling and 125°K on heating.

Powders resulting from these operations are suitably about 100-mesh (i.e., about 90% will pass a 100-mesh U.S. Screen). The powder mixture can be formed into a pellet or other shape by compression or other conventional techniques. The pellets in our work were made with a Carver laboratory hydraulic press, and were about $\frac{1}{2}$ -1" in diameter and $\frac{1}{4}$ " in height. These dimensions are, of course, not critical.

From the foregoing description it will be evident that our process introduces no extraneous substances into the system; viz., no cations other than Tl, Ca, Ba, and Cu enter the system. The process thus results in an oxide mix of extraordinary purity at all stages, from initial powder mixture to finished powder or other shape.

## Example 5

$Y_2O_3$ (10.49 g) was weighed out and dissolved (by heating) in a mixture containing 42.0 g glacial acetic acid and 315.7 g $H_2O$. $BaCO_3$ (39.5 g) was dissolved in the above solution. 807 g $H_2O$ and 28.6 g glacial acetic acid was added, and then 59.9 g copper acetate monohydrate was dissolved in the above. The slightly turbid solution was then filtered through a 0.45 micron filter.

The solution was then spray dried in a Niro spray dryer at the following conditions: inlet temperature = 300°C, outlet temperature = 110°C, air pressure = 4.5 Bars. 51.8 g were collected (fine portion). SEM analysis showed that these particles were spherical and about 2-13 microns in diameter. The product was non-hygroscopic and free-flowing. After intermittent exposure to air it continued to be free-flowing. A comparable sample of spray dried nitrates was hygroscopic and became non-free flowing under the same experimental conditions.

A portion (24 g) of the spray dried acetate powder was placed in an alumina boat and calcined in air at the following schedule: to 400°C at 3°/min, at 400°C for 2 hours, to 800°C at 5°/min, at 800°C for 1 hour. The resulting product was a black friable powder (12.5 g).

The above powder (10.7 g) as fired in oxygen (235 cc/min) under the following schedule: to 950°C in 4.5 hours, at 950°C for 4 hours, to 600°C in 2 hours, to 300°C in 13 hours, to 200°C in 1 hour. 9.6 g of powder were recovered. The powder was pressed into a pellet and was found to exhibit the Meissner effect (float a large magnet) in liquid nitrogen, indicating the pellet was superconducting.

X-ray diffraction of the powder product showed a single phase product, $YBa_2Cu_3O_x$, where x = 6.8-7.0.

## Spray Drying

Another useful spray dryer is a bench scale unit, a Yamato Model GS 21 with a GF-31 attachment, made by Yamato USA, Inc., Northbrook, Illinois. In this unit the atomizer operates with compressed nitrogen, and air preheated to about 150°C is used in the drying chamber. The collecting pot operates on a cyclone principle and is vented to the hood.

Commercial-scale spray dryers are recommended for larger operations. A variety is available, but all are based on two essential functions: (1) the feed is atomized; and (2) the atomized feed is dried in a stream of hot gas. Atomizers take various forms. The two most frequently found are the centrifugal-wheel -- where the feed is flung as a fine spray from a rapidly whirling disk; and the pressure-nozzle atomizer (rather like a garden hose nozzle sprayer). The aim of course is to produce particles such that the largest will be completely dried during its retention time in the hot-gas chamber, where gas flow may be co- or counter- to particle flow. All of these considerations are well within the routine skill of the spray drying art. (Cf. the article, Spray Drying, in Van Nostrand's Scientific Encyclopedia, 6th Ed., 2657-2658 [1983].)

As indicated, spray drying provides mixed salts of extreme purity, since contaminants that would ordinarily be introduced by grinding and regrinding are avoided, as are precipitants that tend to leave undesirable cationic residues, e.g., potassium carbonate.

## Levitation Test for Superconductivity

Various tests are available for the determination of superconductivity. One of these tests is conventional, simple, and is accepted in the art as definitive. This, the so-called levitation test, or Meissner effect, was used in the determinations, and is described below.

A circular wafer of the compound is prepared by calcining and compressing as described above. The wafer is about 1-inch in diameter and about 3/16-inch thick. It is placed in the center of a glass dish, and then liquid nitrogen (77° K) is poured into the dish.

The wafer bubbles a bit at first, as the nitrogen boils on contact, and as surface air is flushed from the wafer. In a few minutes gas evolution diminishes to nearly zero, and the wafer may be assumed to be chilled to approximately the temperature of liquid nitrogen. A chip of a rare earth magnet is now dropped gently over the wafer. If the magnet levitates, i.e., hovers, in the air over the wafer (Meissner effect), the wafer is superconducting.

## Claims

1. Composition comprising a dried, homogeneous at the atomic level, mixture of the monocarboxylates of X, Ba and Cu, wherein X is either Ca or Y; the monocarboxylates being present to provide an atomic ratio of $X_b$-$Ba_c$-$Cu_d$, where b is about 0.5-3, c is about 0.5-3, and d is about 1-4; the monocarboxylates being salts of formic, acetic, propionic, or butyric acid, or mixtures thereof.

2. Homogeneous mixture of the oxides of X, Ba and Cu, wherein X is either Ca or Y; in the atomic ratios of $X_b$-$Ba_c$-$Cu_d$ as defined in Claim 1.

3. Intimate unfired mixture of (i) mixture of Claim 2, wherein X is Ca, with (ii) $Tl_2O_3$; providing a ratio of $Tl_a$-$Ca_b$-$Ba_c$-$Cu_d$ oxides where a is about 0.5-3; and b, c, and d are as provided in Claim 1.

4. Fired mixture of Claim 3, being a superconductor.

5. Composition as defined in Claim 1, wherein X is Y.

6. Homogeneous mixture of Claim 2 wherein X is Y; b is 1, c is 2 and d is 3.

7. Fired mixture of Claim 6, being a superconductor.

8. Process of preparing a pre-mix comprising preparing a solution of monocarboxylates of X, Ba, and Cu in water or in monohydroxy alkanol of 1-4 carbons to provide about 5-25 weight percent monocarboxylates in the solution, wherein X is Ca or Y; the monocarboxylates being present in amounts to provide an atomic ratio of $X_b$-$Ba_c$-$Cu_d$, where b, c and d are as defined in Claim 1; the monocarboxylates being salts of formic, acetic, propionic, or butyric acid; and spray drying to produce nonhygroscopic, spherical, free-flowing, homogeneous product.

9. A process comprising heating the dried monocarboxylate mixture of Claim 8, thereby forming a homogeneous mixture of the oxides of X, Ba and Cu, wherein X is Ca or Y.

10. A process comprising intimately admixing the oxide mixture of Claim 9, wherein X is Ca, with $Tl_2O_3$ in an amount to provide an atomic ratio of $Tl_a$-$Ca_b$-$Ba_c$-$Cu_d$-O where a is about 0.5-3 and, b, c and d are as defined in Claim 8.

11. Process comprising heating the oxide mixture of Claim 10 to form a superconductor.

12. Process comprising heating the oxide mixture of Claim 9, wherein X is Y, to form a superconductor

13. Process according to Claim 12 wherein the molecular ratio of oxides is $Y_1$-$Ba_2$-$Cu_3$.

14. Process comprising the sequential steps of:

(a) preparing a pre-mix comprising dissolving monocarboxylates of Ca, Ba, and Cu in water or in a monohydroxy alkanol of 1-4 carbons to provide about 5-25 weight % monocarboxylates in the solution; the Ca, Ba, and Cu being present in amounts to provide an atomic ratio of $Ca_b$-$Ba_c$-$Cu_d$, where b is about 0.5-3; c is about 0.5-3; and d is about 1-4; the monocarboxylate being formate, acetate, propionate, or butyrate;

(b) drying the monocarboxylate solution of (a), thereby to provide a dry homogeneous monocarboxylate acetate mixture;

(c) heating the dry mixture of (b) to convert the monocarboxylates to the oxides, thereby forming a homogeneous mixture of the oxides of Ba, Ca, and Cu;

(d) admixing the oxide mixture of (c) with $Tl_2O_3$ in an amount to provide an atomic ratio of $Tl_a$-$Ca_b$-$Ba_c$-$Cu_d$ where a is about 0.5-3 and b, c, and d are as defined in (a); and

(e) heating the oxide mixture of (d) to form a superconductor.

15. Process comprising the sequential steps of:

(a) preparing a pre-mix comprising dissolving monocarboxylates of Y, Ba, and Cu in water or in monohydroxy alkanol of 1-4 carbons to provide about 5-25 weight % monocarboxylates in the solution; the Y, Ba, and Cu being present in amounts to provide an atomic ratio of $Y_b$-$Ba_c$-$Cu_d$, where b is about 0.5-3; c is about 0.5-3; and d is about 1-4; the monocarboxylate being formate, acetate, propionate, or butyrate;

(b) drying the monocarboxylate solution of (a), thereby to provide a dry homogeneous monocarboxylate acetate mixture;

(c) heating the dry mixture of (b) to convert the monocarboxylates to the oxides, thereby forming a homogeneous mixture of the oxides of Y, Ba, and Cu; and

(d) heating the oxide mixture of (d) to form a superconductor.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| E | EP-A-0 309 322 (RHONE-POULENC CHIMIE) * claims 1,17,18; column 3, lines 56-59 * | 1,2,5-9 ,12,13, 15 | C 04 B 35/00 H 01 L 39/24 |
| | --- | | |
| P,A | WO-A-8 809 701 (E.I. DU PONT DE NEMOURS & CO.) * claims 1,14; example 1 * | 1,8,15 | |
| | --- | | |
| P,A | EP-A-0 280 292 (SUMITOMO ELECTRIC IND., LTD.) * claims 1,7; column 3, line 41 * | 1,3,8, 10,14, 15 | |
| | --- | | |
| X | PHYSICAL REVIEW B: CONDENS. MATTER vol. 37, no. 7, 1st March 1988, pages 3727-3729; R. PANAYAPPAN et al.:"Preparation of superconducting YBa2Cu3O7 from the corresponding metal formates"* pages 3727,3728 * | 1,2,5-7 | |
| | --- | | |
| D,A | PHYSICAL REVIEW LETTERS vol. 60, no. 16, 18th April 1988, pages 1657-1660; R.M. HAZEN et al.:"100-K Superconducting Phases in the TI-Ca-Ba-Cu-O System" | 3,10,14 | TECHNICAL FIELDS SEARCHED (Int. Cl.5) C 04 B 35/00 H 01 L 39/24 |
| | --- | | |
| P,X | EP-A-0 298 646 (HALDOR TOPSOE A/S) * claims 1,2,4,5 * | 1,2,5-7 ,12,13 | |
| P,A | | 8,9,12- 15 | |
| | --- | | |
| P,X | MATERIALS RESEARCH BULLETIN vol. 24, no. 1, 1989, pages 11-22, Pergamon Press Ltd., US; P. ODIER et al.:"Chemical Inhomogeneities in YBaCuO Produced by Conventional Sintering" * pages 13,14 * | 1,2,5-9 ,12,13, 15 | |
| | ----- | | |

The present search report has been drawn up for all claims

| Place of search | Date of completion of the search | Examiner |
|---|---|---|
| BERLIN | 20-06-1989 | STROUD J.G. |

EPO FORM 1503 03.82 (P0401)